# EUROPEAN PATENT APPLICATION

(11) **EP 4 624 879 A1**
(43) Date of publication of application: **01.10.2025**
(21) Application number: 25165526.2
(22) Date of filing: 24.03.2025
(51) Int. Cl.: G01H 11/08, G01N 29/02, G01N 29/036, G01N 29/22, G01N 29/24, G01N 29/32

(54) **SENSING SENSOR MODULE AND SENSOR MODULE HEAT DISSIPATION**

(30) Priority: 28.03.2024 JP 2024052989
(71) Applicant: Nihon Dempa Kogyo Co., Ltd., Tokyo 151-8569 (JP)
(72) Inventor: TSUCHIYA, Shoichi, Saitama (JP)
(74) Representative: Becker, Eberhard

(57) **Abstract**

A sensing sensor module (S100) and a sensor module heat dissipation structure are provided. The sensing sensor module (S100) includes a piezoelectric oscillation portion (20) in which a reaction electrode (22) to which a target substance in a gas adheres and a reference electrode (23) to which the target substance does not adhere are disposed on a sensor substrate (21) as a piezoelectric resonator, a cooling element (72), and a supporting member (11). The cooling element (72) cools the piezoelectric oscillation portion (20). The supporting member (11) supports the cooling element (72). The supporting member (11) has a center portion (16) at which the cooling element (72) is arranged and a flange-shaped base portion (17) that has a circular ring shape and extends outward in a radial direction of the circular ring around the center portion (16). The base portion (17) dissipates heat from the center portion (16).

## Description

### TECHNICAL FIELD

This disclosure relates to a sensing sensor module and a sensor module heat dissipation structure.

### DESCRIPTION OF THE RELATED ART

Conventionally, as a sensing sensor that senses a substance contained in a gas, there has been known a Quartz Crystal Microbalance (QCM) type one using a crystal unit. In this sensing sensor, a target substance in the gas introduced into the sensor adheres to the crystal unit, and a kind, an amount of adhesion, and the like of the adhered target substance are detected (for example, see Japanese Unexamined Patent Application Publication No. 2020-139788).

The sensing sensor as described above has conventionally been configured to be disposed and used inside a vacuum chamber of a semiconductor manufacturing apparatus. In such a configuration, it has been necessary to dispose a cooling plate inside the vacuum chamber for the sensing sensor to dissipate heat, thus leading to a problem that a structure becomes complicated.

A need thus exists for a sensing sensor module and a sensor module heat dissipation structure which are not susceptible to the drawback mentioned above.

### SUMMARY

According to an aspect of this disclosure, there is provided a sensing sensor module that includes a piezoelectric oscillation portion in which a reaction electrode to which a target substance in a gas adheres and a reference electrode to which the target substance does not adhere are disposed on a sensor substrate as a piezoelectric resonator, a cooling element, and a supporting member. The cooling element cools the piezoelectric oscillation portion. The supporting member supports the cooling element. The supporting member has a center portion at which the cooling element is arranged and a flange-shaped base portion that has a circular ring shape and extends outward in a radial direction of the circular ring around the center portion. The base portion dissipates heat from the center portion.

The sensing sensor module may further include an exterior cover that has an opening portion through which the gas passes, the exterior cover covering the piezoelectric oscillation portion and the cooling element. The base portion may have a first surface and a second surface on an opposite side of the first surface. The exterior cover may be arranged to project from a side of the first surface. The first surface may be a plane that extends in a direction perpendicular to a projection direction of the exterior cover. The second surface may be an inclined surface that is inclined such that a distance to the first surface decreases toward an outer edge in the radial direction.

In the sensing sensor module, the center portion and the base portion may be configured of a single member.

According to another aspect of this disclosure, there is provided a sensor module heat dissipation structure that includes the sensing sensor module, a center ring having an outer periphery portion on which an O-ring is disposed, an interface member disposed at a part of a semiconductor manufacturing apparatus, and a clamp member. The interface member has a flange portion. The clamp member is configured to secure the base portion and the flange portion by pressing the base portion and the flange portion in a direction in which the base portion and the flange portion approach one another while the O-ring is interposed between the base portion of the sensing sensor module and the flange portion of the interface member.

In the sensor module heat dissipation structure, the sensing sensor module may be arranged in a direction to which the piezoelectric oscillation portion is opposed in a space on a vacuum chamber side of the semiconductor manufacturing apparatus.

The present disclosure is advantageous as it is able to provide a sensing sensor module and a sensor module heat dissipation structure that allow simplification of a structure without the necessity of disposing a cooling plate inside a vacuum chamber of a semiconductor manufacturing apparatus.

### BRIEF DESCRIPTION OF THE DRAWINGS

The foregoing and additional features and characteristics of this disclosure will become more apparent from the following detailed description considered with reference to the accompanying drawings, wherein:
FIG. 1 is a schematic diagram of a semiconductor manufacturing system including a sensor module heat dissipation structure;
FIG. 2 is an exploded perspective view of the sensor module heat dissipation structure;
FIG. 3 is a perspective view of a part of components of the sensor module heat dissipation structure;
FIG. 4 is a side view of the part of the components of the sensor module heat dissipation structure;
FIG. 5 is a perspective view of a sensing sensor module;
FIG. 6 is a cross-sectional view schematically illustrating a configuration of the sensing sensor module;
FIG. 7 is a partial perspective cross-sectional view of the sensing sensor module;
FIG. 8 is a cross-sectional view of the sensing sensor module in an assembled condition; and
FIG. 9 is a drawing illustrating a conventional exemplary configuration.

### DETAILED DESCRIPTION

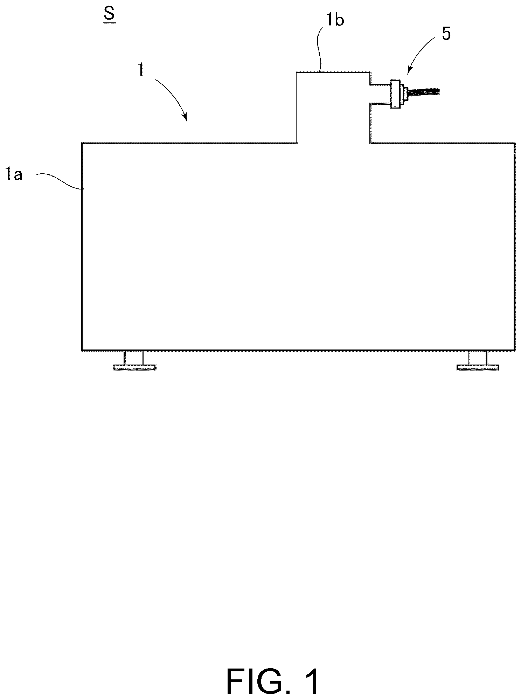

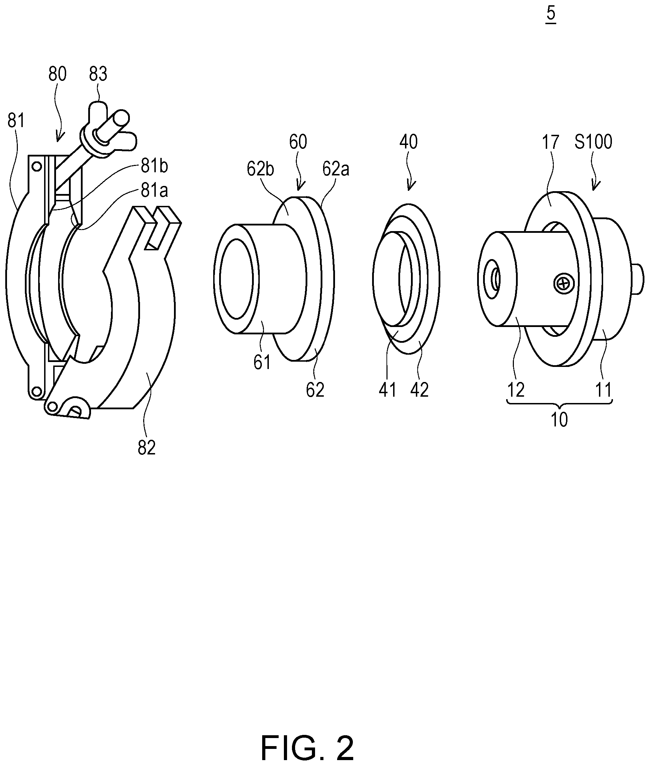

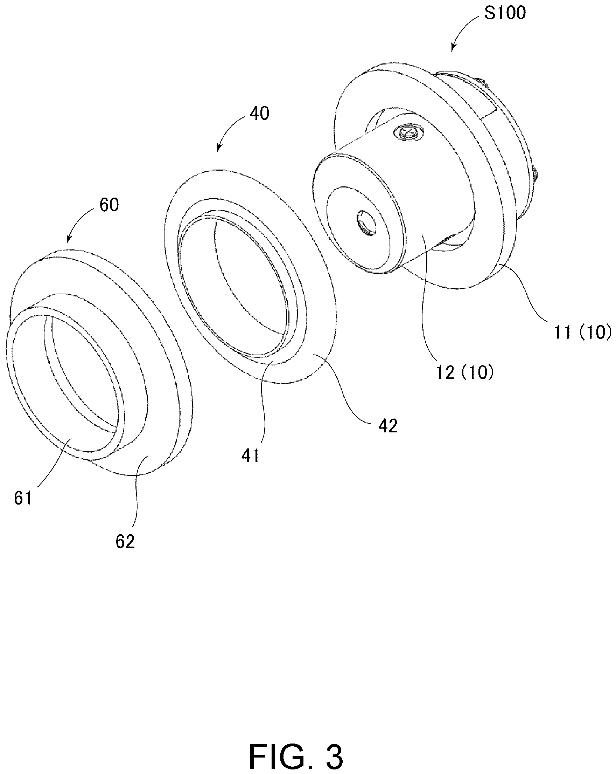

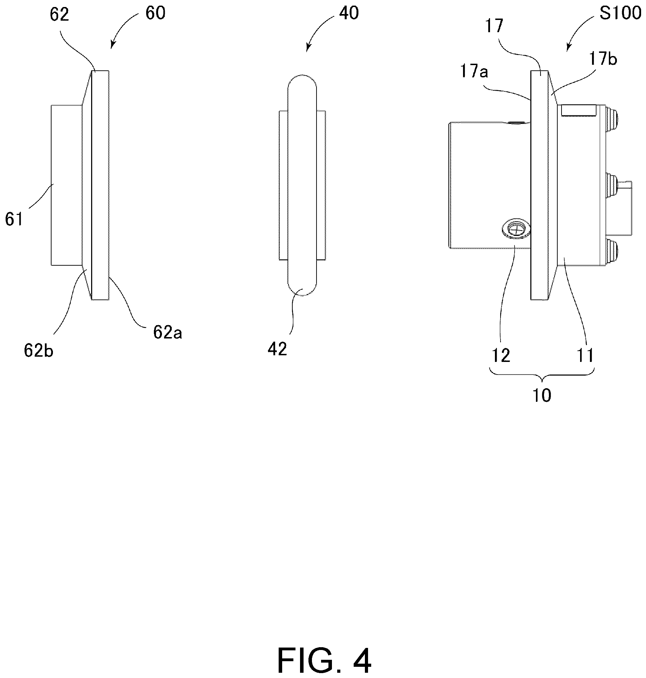

FIG. 1 is a schematic diagram of a semiconductor manufacturing system including a sensor module heat dissipation structure. FIG. 2 is an exploded perspective view of the sensor module heat dissipation structure. FIG. 3 is a perspective view of a part of components of the sensor module heat dissipation structure. FIG. 4 is a side view of the part of the components of the sensor module heat dissipation structure.

A semiconductor manufacturing system S in FIG. 1 includes a semiconductor manufacturing apparatus 1 and a sensor module heat dissipation structure 5.

The semiconductor manufacturing apparatus 1 includes an apparatus main body 1a and an equipment connection portion 1b as an example. The apparatus main body 1a is provided for a production process of a semiconductor, and includes a vacuum chamber. The equipment connection portion 1b is disposed to communicate with a space inside the vacuum chamber. The semiconductor manufacturing apparatus 1 is not limited to a specific one, and various kinds of devices are allowed to be used.

The sensor module heat dissipation structure 5 is disposed at a part of the equipment connection portion 1b in this example. The sensor module heat dissipation structure 5 specifically includes a sensing sensor module S100, a center ring 40, an interface member 60, and a clamp member 80, as illustrated in FIG. 2.

The sensing sensor module S100 is a Quartz Crystal Microbalance (QCM) sensor as an example. The detailed structure of the sensing sensor module S100 will be described with reference to another drawing. The semiconductor manufacturing system S has the sensing sensor module S100 externally mounted on a part of the device, not inside the vacuum chamber of the semiconductor manufacturing apparatus 1. While details will be described below, the sensing sensor module S100 is secured to the interface member 60 while an O-ring 42 is interposed between a base portion 17 of the sensing sensor module S100 and a flange portion 62 of the interface member 60.

The center ring 40 has a sealing member main body 41 and the O-ring 42. The sealing member main body 41 has a circular ring shape as a whole, and the O-ring 42 is disposed around an outer periphery portion thereof. The O-ring 42 is a sealing member formed of a material with elasticity.

The interface member 60 is a component disposed at a part of the semiconductor manufacturing apparatus 1. The interface member 60 has a cylindrical main body portion 61 and the flange portion 62. The interface member 60 is a cylindrical component conforming to "NW25" standard as a specific example.

The cylindrical main body portion 61 has a cylindrical shape. The flange portion 62 extends outward in a radial direction from the cylindrical main body portion 61. The flange portion 62 has, for example, an outline in a circular shape.

The flange portion 62 has a first surface 62a and a second surface 62b (see FIG. 4). The first surface 62a is a plane extending in a direction perpendicular to a central axis of the cylindrical main body portion 61. The second surface 62b is an inclined surface whose distance to the first surface 62a decreases toward an outer edge in the radial direction. The second surface 62b specifically has an outer peripheral surface in a truncated cone shape.

The clamp member 80 has a first member 81, a second member 82, and a fastening member 83, as illustrated in FIG. 2. The first member 81 and the second member 82 both have a semicircular arc shape. The first member 81 has an inclined surface 81a and an inclined surface 81b that are brought closer to one another toward an outer edge in the radial direction. Similarly, the second member 82 also has a pair of inclined surfaces that are brought closer to one another toward an outer edge in the radial direction. The flange portion 62, the O-ring 42, and the base portion 17 are interposed between these inclined surfaces. A base end portion of the first member 81 and a base end portion of the second member 82 are coupled to one another. A distal end portion of the first member 81 and a distal end portion of the second member 82 are secured by the fastening member 83.

Fastening the fastening member 83 of the clamp member 80 configured as described above causes the base portion 17 and the flange portion 62 to be pressed in a direction in which they approach one another, and the flange portion 62, the O-ring 42, and the base portion 17 are secured while being sealed by the O-ring 42.

### (Structure of Sensing Sensor Module S100)

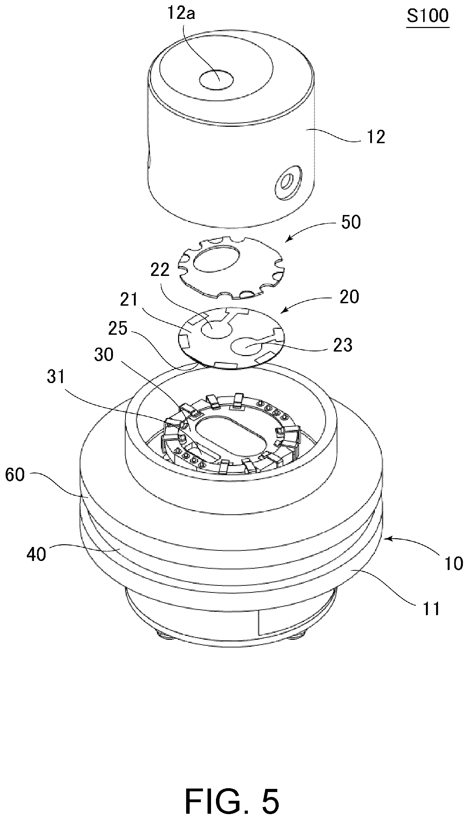

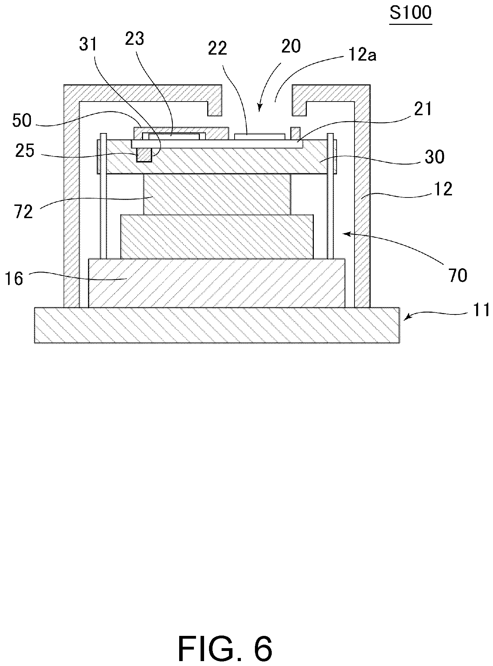

FIG. 5 is a perspective view of a sensing sensor module. FIG. 6 is a cross-sectional view schematically illustrating a configuration of the sensing sensor module. Note that, while FIG. 5 and FIG. 6 exemplarily illustrate the sensing sensor module S100 having a structure in which an electrode cover 50 (details will be described below) is disposed and a temperature sensor 25 (details will be described below) is arranged on a lower surface side of a piezoelectric oscillation portion 20, the present disclosure is not limited to the sensing sensor module having such a specific structure.

The sensing sensor module S100 includes a housing 10, the piezoelectric oscillation portion 20, a support substrate 30, the electrode cover 50, and a base structure 70, as illustrated in FIG. 5 and FIG. 6.

The operating principle of the sensing sensor module S100 is conventionally publicly known, and therefore, a brief description will be given below. In the sensing sensor module S100, a piezoelectric resonator of the piezoelectric oscillation portion 20 is cooled by a Peltier element, and a gas supplied from the outside and entering the sensing sensor module S100 is cooled by contacting a reaction electrode 22 and adheres to the reaction electrode 22. Thereafter, while respective oscillation frequencies f1, f2 of the reaction electrode 22 and a reference electrode 23 are being obtained, the temperature of the piezoelectric resonator is increased. This temperature increase causes a target substance adhering to the reaction electrode 22 to detach. This detachment significantly changes the oscillation frequency f1. On the other hand, the oscillation frequency f2 of the reference electrode 23 hardly changes. On the basis of such a difference between the oscillation frequencies f1 and f2, a degree of change in the oscillation frequency f1, and the like, a mass and/or a kind of the target substance are identified.

### (Description of Each Portion)

The housing 10 has a supporting member 11 and an exterior cover 12 as illustrated in FIG. 4 and FIG. 5. The supporting member 11 supports the piezoelectric oscillation portion 20, the support substrate 30, the electrode cover 50, and the like.

The exterior cover 12 is mounted on the supporting member 11 so as to cover the piezoelectric oscillation portion 20, the electrode cover 50, and the like. The exterior cover 12 has a cylindrical shape in this example. The exterior cover 12 has an upper surface on which an opening portion 12a is formed. The opening portion 12a is a portion through which the gas containing the target substance passes. The gas is not limited to a specific object, but, as an example, is a halogen-based gas with high corrosivity generated in the semiconductor manufacturing apparatus that performs plasma etching. The exterior cover 12 is arranged to project from a side of a first surface 17a (details will be described below) of the base portion 17 as illustrated in FIG. 4. The sensing sensor module S100 is arranged in a direction to which the piezoelectric oscillation portion 20 is opposed in the space inside the vacuum chamber of the semiconductor manufacturing apparatus 1.

The piezoelectric oscillation portion 20 includes a sensor substrate 21 and the temperature sensor 25 as illustrated in FIG. 5. The sensor substrate 21 has an outline formed into an approximately circular shape in this example. The sensor substrate 21 is a crystal vibration plate as a piezoelectric resonator.

The sensor substrate 21 has the reaction electrode 22 and the reference electrode 23. The reaction electrode 22 and the reference electrode 23 are formed on an upper surface of the sensor substrate 21. The sensor substrate 21 is mounted on the support substrate 30 such that the reaction electrode 22 and the reference electrode 23 face a side of the opening portion 12a as illustrated in FIG. 6.

The reaction electrode 22 is an electrode to which the target substance contained in the gas adheres. The reaction electrode 22 is arranged at a position facing the opening portion 12a as illustrated in FIG. 6. The reference electrode 23 is formed at a position adjacent to the reaction electrode 22 on the upper surface of the sensor substrate 21. The reference electrode 23 is an electrode to which the target substance in the gas does not adhere. The reaction electrode 22 and the reference electrode 23 both have an outline in a circular shape as an example.

The temperature sensor 25 is a sensor for detecting a temperature of the sensor substrate 21. On the basis of an output value of the temperature sensor 25, an operation of the Peltier element (details will be described below) is controlled, and the temperature of the sensor substrate 21 as a crystal unit is adjusted.

The support substrate 30 is a member that supports the piezoelectric oscillation portion 20. The support substrate 30 is a Low Temperature Co-fired Ceramics (LTCC) substrate as an example. A cavity 31 is formed on the support substrate 30. The cavity 31 is a depressed portion that receives the temperature sensor 25. The cavity 31 is engraved in a thickness direction of the support substrate 30.

The base structure 70 includes an oscillation control circuit (not illustrated) and a Peltier element 72 (see FIG. 6). The oscillation control circuit is a circuit for oscillating the piezoelectric resonator. The oscillation control circuit is arranged on a side of the supporting member 11 with respect to the Peltier element 72 as an example.

The Peltier element 72 is a cooling element that cools the piezoelectric oscillation portion 20. The support substrate 30 is disposed so as to be in contact with the Peltier element 72. The Peltier element 72 is supported by the supporting member 11 in this example. The Peltier element 72 may be arranged so as to be in direct contact with a part of the supporting member 11, or may be supported by the supporting member 11 with another member being interposed. Heat of the Peltier element 72 is configured to be transmitted to the supporting member 11 via a center portion 16 (FIG. 6, details will be described below).

The temperature sensor 25 is arranged on a surface on the opposite side of a surface on which the reaction electrode 22 and the reference electrode 23 are disposed. The temperature sensor 25 is positioned inside the cavity 31 when the sensor substrate 21 is mounted on the support substrate 30. Specifically, as an example, the temperature sensor 25 and a conductive adhesive arranged in contact with the temperature sensor 25 are arranged so as to fit into the cavity 31. The cavity 31 is covered with the sensor substrate 21.

The electrode cover 50 is a member that covers the piezoelectric oscillation portion 20 as illustrated in FIG. 5 and FIG. 6. The electrode cover 50 is formed into a circular plate shape as a whole. The electrode cover 50 has a through hole. The through hole is formed to be larger than the reaction electrode 22. The through hole is also formed to be larger than the opening portion 12a in this example. The reaction electrode 22 is exposed via the through hole with the electrode cover 50 being mounted on the piezoelectric oscillation portion 20. Such a configuration enables the target substance in the gas to adhere to the reaction electrode 22 and the sensing sensor module S100 to detect this target substance even when the electrode cover 50 is mounted on the piezoelectric oscillation portion 20.

### (Heat Dissipation Structure)

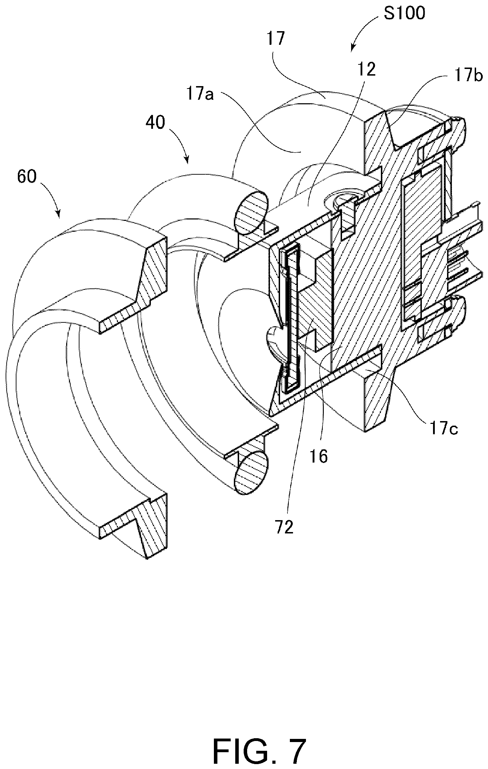

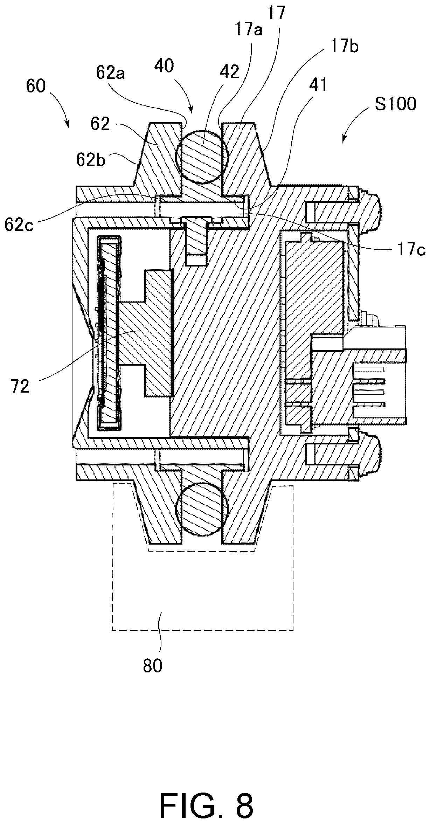

FIG. 7 is a partial perspective cross-sectional view of the sensing sensor module. FIG. 8 is a cross-sectional view of the sensing sensor module in an assembled condition. The supporting member 11 of the sensing sensor module S100 has the center portion 16 and the base portion 17 as illustrated in FIG. 7.

The center portion 16 is a portion where the Peltier element 72 as the cooling element is arranged. The Peltier element 72 does not necessarily have to be arranged so as to be in direct contact with the center portion 16.

The base portion 17 has a circular ring shape. The base portion 17 extends outward in the radial direction of the circular ring around the center portion 16. The base portion 17 is provided in a flange shape, and has a function of dissipating heat from the center portion 16. The base portion 17 is integrally disposed with the center portion 16 in this example. That is, the base portion 17 and the center portion 16 are configured of a single member.

The base portion 17 also has the first surface 17a and a second surface 17b on the opposite side of the first surface 17a. The first surface 17a is a plane extending in a direction perpendicular to a projection direction of the exterior cover 12. The second surface 17b is an inclined surface that is inclined such that the distance to the first surface 17a decreases toward the outer edge in the radial direction.

The sensing sensor module S 100 thus configured is connected to the interface member 60 in the state as illustrated in FIG. 8 by fastening the clamp member 80 (partly schematically illustrated in FIG. 8). In the same drawing, the interface member 60 is on a vacuum side communicating with the vacuum chamber of the semiconductor manufacturing apparatus 1, and the sensing sensor module S 100 is on an atmosphere side. In the assembled condition in FIG. 8, the O-ring 42 of the center ring 40 seals between the first surface 17a on the base portion 17 and the first surface 62a on the flange portion 62 of the interface member 60. Since both the second surface 17b and the second surface 62b are inclined surfaces, the more the clamp member 80 is fastened, the more the base portion 17 and the flange portion 62 are pressed against one another, and thus, a satisfactory seal performance is provided.

One end side of a ring-shaped portion of the sealing member main body 41 enters a ring-shaped depressed portion 17c of the base portion 17, and the other end side of the ring-shaped portion enters a ring-shaped depressed portion 62c of the flange portion 62.

The sensing sensor module S100 is thus secured to the interface member 60, thereby enabling proper detection of a detection target in the gas from the vacuum chamber of the semiconductor manufacturing apparatus 1.

With the configuration of the embodiment described above, the base portion 17 functions as a mounting portion clamped by the clamp member 80 and also functions as a heat dissipation portion, and therefore, the heat from the Peltier element 72 of the sensing sensor module S100 can be properly released. The heat from the Peltier element 72 is also transmitted to the flange portion 62, and therefore is also dissipated through the flange portion 62, and as a result, the heat of the Peltier element 72 is properly dissipated.

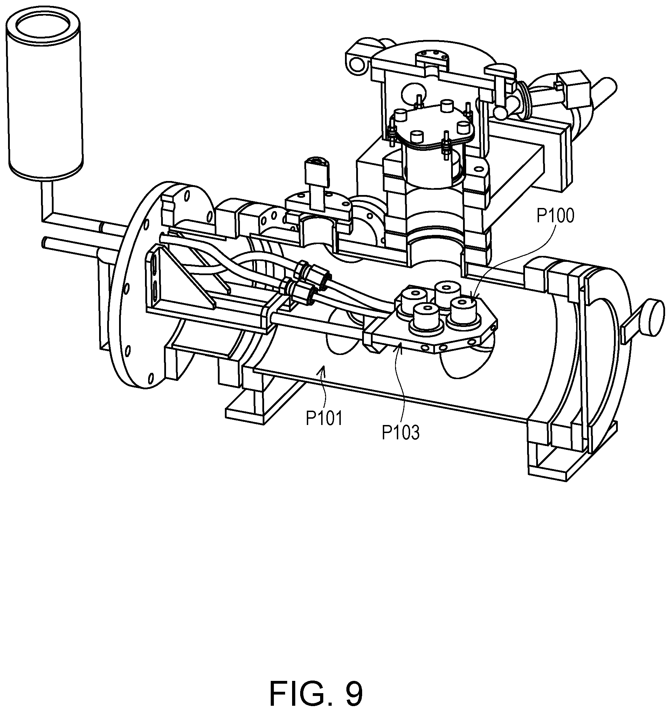

FIG. 9 is a drawing illustrating a conventional exemplary configuration. With the configuration of the embodiment, compared with the configuration in which a cooling plate P103 for cooling a sensing sensor module P100 is arranged inside a vacuum chamber P101 as in FIG. 9, there is no necessity to arrange the cooling plate P103 inside the vacuum chamber P101, and therefore, the configuration can be simplified, and a cooling chiller or water cooling using liquid nitrogen is also no longer necessary. In addition, an expensive feedthrough, vacuum cable, or the like is also no longer necessary.

### (Modification)

In the configuration of the present disclosure, the piezoelectric oscillation portion 20 and the like of the sensing sensor module S 100 are arranged in a region on the vacuum side, and detection signals are output to the outside through a signal line extracted to a region on the atmosphere side. In such a configuration, the signal line may be secured with a predetermined hole through which the signal line passes being filled with a sealing material, such as an epoxy, such that a proper separation is made between the region on the atmosphere side and the region on the vacuum side.

While this disclosure has been described above using the embodiments, the technical scope of this disclosure is not limited to the scope described in the above-described embodiments, and various modifications and changes are possible within the scope of the gist. For example, this disclosure can be functionally or physically distributed and integrated in any unit for all or a part thereof. Additionally, a new embodiment created by any combination of the plurality of embodiments is also included in the embodiments of this disclosure. Effects of the new embodiment created by the combination also include the effects of the original embodiments.

## Claims

1. A sensing sensor module (S100) comprising:
a piezoelectric oscillation portion (20) in which a reaction electrode (22) to which a target substance in a gas adheres and a reference electrode (23) to which the target substance does not adhere are disposed on a sensor substrate (21) as a piezoelectric resonator;
a cooling element (72) that cools the piezoelectric oscillation portion (20); and
a supporting member (11) that supports the cooling element (72), wherein
the supporting member (11) has:
a center portion (16) at which the cooling element (72) is arranged; and
a flange-shaped base portion (17) that has a circular ring shape and extends outward in a radial direction of the circular ring around the center portion (16), the base portion (17) dissipating heat from the center portion (16).

2. The sensing sensor module (S100) according to claim 1, further comprising
an exterior cover (12) that has an opening portion (12a) through which the gas passes, the exterior cover (12) covering the piezoelectric oscillation portion (20) and the cooling element (72), wherein
the base portion (17) has a first surface (17a) and a second surface (17b) on an opposite side of the first surface (17a),
the exterior cover (12) is arranged to project from a side of the first surface (17a),
the first surface (17a) is a plane that extends in a direction perpendicular to a projection direction of the exterior cover (12), and
the second surface (17b) is an inclined surface that is inclined such that a distance to the first surface (17a) decreases toward an outer edge in the radial direction.

3. The sensing sensor module (S100) according to claim 1 or 2, wherein
the center portion (16) and the base portion (17) are configured of a single member.

4. A sensor module heat dissipation structure comprising:
the sensing sensor module (S100) according to claim 1 or 2;
a center ring (40) having an outer periphery portion on which an O-ring (42) is disposed;
an interface member (60) disposed at a part of a semiconductor manufacturing apparatus (1), the interface member (60) having a flange portion (62); and
a clamp member (80), wherein
the clamp member (80) is configured to secure the base portion (17) and the flange portion (62) by pressing the base portion (17) and the flange portion (62) in a direction in which the base portion (17) and the flange portion (62) approach one another while the O-ring (42) is interposed between the base portion (17) of the sensing sensor module (S100) and the flange portion (62) of the interface member (60).

5. The sensor module heat dissipation structure according to claim 4, wherein
the sensing sensor module (S100) is arranged in a direction to which the piezoelectric oscillation portion (20) is opposed in a space on a vacuum chamber side of the semiconductor manufacturing apparatus (1).
